# EUROPEAN PATENT APPLICATION

(11) **EP 4 625 736 A1**
(43) Date of publication of application: **01.10.2025**
(21) Application number: 24894303.7
(22) Date of filing: 08.08.2024
(51) Int. Cl.: H02H 7/18, H02J 7/00, G01R 19/10, G01R 19/165, G01R 19/00

(54) **ENERGY STORAGE SYSTEM, AND PROTECTION DEVICE AND PROTECTION METHOD THEREOF**

(30) Priority: 22.11.2023 KR 20230163660
(71) Applicant: LG Energy Solution, Ltd., Seoul 07335 (KR)
(72) Inventor: JOE, Reejin, Daejeon 34122 (KR); KIM, Jong Wan, Daejeon 34122 (KR)
(74) Representative: BCKIP Part mbB
(86) International application number: PCT/KR2024/011757
(87) International publication number: WO 2025/110406

(57) **Abstract**

An energy storage system includes a battery, a first battery terminal and a second battery terminal to which the battery is connected, a first inverter terminal and a second inverter terminal to which an inverter is connected, a switch connected between the second battery terminal and the second inverter terminal, and protection circuitry configured to determine whether to open the switch based on a difference between a first voltage detected at the first inverter terminal and a second voltage detected at the second inverter terminal, the first voltage, and the second voltage.

## Description

### [Technical Field]

### CROSS-REFERENCE TO RELATED APPLICATION

This application claims priority to and the benefit of Korean Patent Application No. 10-2023-0163660 filed in the Korean Intellectual Property Office on November 22, 2023, the entire contents of which are incorporated herein by reference.

The disclosure relates to an energy storage system and its protection apparatus and protection method.

### [Background Art]

Energy storage systems (ESSs), which store power and provide it when it is needed, are used in a variety of applications. For example, the energy storage systems may be used to store excess power from power plants and provide power when there is a temporary shortage. The energy storage systems may also be miniaturized and used in buildings, factories, and homes for power outage preparedness or peak power curtailment. The energy storage systems may also be used to store power generated from renewable energy sources and utilize the stored power at times of need.

An inverter is used to store power in the energy storage system and to deliver power from the energy storage system to the load. Recently, as a power generation system that uses a high voltage, such as solar power, is connected to the inverter, if a fault occurs in the inverter, the high voltage may be fed to the energy storage system, which may destroy the energy storage system.

### [Disclosure]

### [Technical Problem]

Some embodiments may provide an energy storage system and its protection apparatus and protection method for protecting the energy storage system in the event of an inverter fault.

### [Technical Solution]

According to some embodiments, an energy storage system may include a battery, a first battery terminal and a second battery terminal to which the battery is connected, a first inverter terminal and a second inverter terminal to which an inverter is connected, a switch connected between the second battery terminal and the second inverter terminal, and protection circuitry configured to determine whether to open the switch based on a difference between a first voltage detected at the first inverter terminal and a second voltage detected at the second inverter terminal, the first voltage, and the second voltage.

According to some embodiments, a protection apparatus of an energy storage system including a battery and a switch configured to a connection between the battery and an inverter, may include a voltage dividing circuit configured to divide a voltage at a first inverter terminal connected to a first terminal of the inverter to output a first voltage, and divide a voltage at a second inverter terminal connected to a second terminal of the inverter to output a second voltage; an adder configured to calculate a difference between the first voltage and the second voltage; a first comparator configured to compare the difference between the first voltage and the second voltage with a first reference voltage; a second comparator configured to compare the first voltage with a second reference voltage; a third comparator configured to compare the second voltage with a third reference voltage; a logic circuit configured to perform a logical operation on a first output signal of the first comparator, a second output signal of the second comparator, and a third output signal of the third comparator; and a switch control circuit configured to control the switch based on a fourth output signal of the logic circuit.

According to some embodiments, a method of protecting an energy storage system comprising a battery and a switch configured to control a connection between the battery and an inverter, may include detecting a voltage at a first inverter terminal connected to a first terminal of the inverter to output a first voltage, detect a voltage at a second inverter terminal connected to a second terminal of the inverter to output a second voltage, comparing a difference between the first voltage and the second voltage with a first reference voltage, comparing the first voltage with the second reference voltage, comparing the second voltage with a third reference voltage, and opening the switch in response to the difference between the first voltage and the second voltage being greater than the first reference voltage, the first voltage being greater than the second reference voltage, or the second voltage being greater than the third reference voltage.

### [Description of the Drawings]

FIG. 1 is a diagram illustrating an example of a power supply system according to some embodiments.
FIG. 2 is a diagram illustrating an example of an energy storage system according to some embodiments.
FIG. 3 is a diagram illustrating an example of protection circuitry of an energy storage system according to some embodiments.
FIG. 4 is a diagram illustrating an example of protection circuitry of an energy storage system according to some embodiments.
FIG. 5 is a flowchart illustrating an example of a protection method of an energy storage system according to some embodiments.

### [Mode for Invention]

In the following detailed description, only certain embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

When it is described that an element is "connected" to another element, it should be understood that the element may be directly connected to the other element or connected to the other element through a third element. On the other hand, when it is described that an element is "directly connected" to another element, it should be understood that the element is connected to the other element through no third element.

As used herein, a singular form may be intended to include a plural form as well, unless the explicit expression such as "one" or "single" is used.

In flowcharts described with reference to the drawings, the order of operations or steps may be changed, several operations or steps may be merged, a certain operation or step may be divided, and a specific operation or step may not be performed.

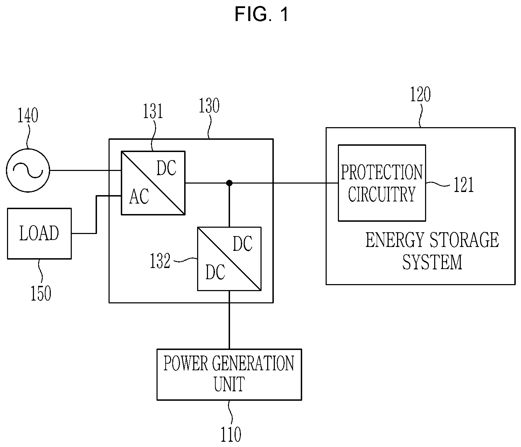

FIG. 1 is a diagram illustrating an example of a power supply system according to some embodiments.

Referring to FIG. 1, an power supply system may include a power generation unit 110, an energy storage system (or energy storage apparatus) 120, an inverter 130, a grid 140, and a load 150.

The power generation unit 110 may generate electrical energy. The power generation unit 110 may be, for example, but not limited to, a solar power system, a wind power system, a tidal power system, or a geothermal power system. For example, if the solar power system is used, the power generation unit 110 may include a solar cell array that converts solar energy into electrical energy. The solar cell array may include a plurality of solar cell modules, and the solar cell module may include a plurality of solar cells connected in series or parallel to convert the solar energy into the electrical energy and generate a predetermined voltage and current.

The energy storage system 120 may charge the electrical energy supplied from the power generation unit 110 and discharge the charged electrical energy to supply it to the grid 140 or load 150. For example, when the grid 140 or load 150 is lightly loaded, the energy storage system 120 may receive idle power from the power generation unit 110 and charge it. If the grid 140 or load 150 is overloaded, the energy storage system 120 may discharge the charged power and provide the power to the grid 140 or load 150.

The inverter 130 may convert direct current (DC) power to alternating current (AC) power. The inverter 130 may convert DC power supplied by the power generation unit 110 or DC power supplied by the energy storage system 120 into AC power. In some embodiments, the inverter 130 may be a three-phase inverter. In some embodiments, when the power generation unit 110 uses a high voltage, the inverter 130 may include an inverter 131 that converts DC power to AC power and a DC/DC converter 132 that converts the DC power supplied by the power generation unit 110 to DC power. The energy storage system 120 may charge the DC power supplied by the DC/DC converter 132. The inverter 131 may convert the DC power supplied by the energy storage system 120 or the DC power supplied by the DC/DC converter 132 to the AC power, which is supplied to the grid 140 or to the load 150.

The grid 140 may be a power network with power plants, substations, transmission and distribution, and the like. The load 150 may be a device that consumes power.

The energy storage system 120 may include protection circuitry (or protection device) 121 that detects a fault in the inverter 130 and protects the energy storage system 120 in the event of the fault in the inverter 130. In some embodiments, the protection circuitry 121 may disconnect an electrical connection between the energy storage system 120 and the inverter 130.

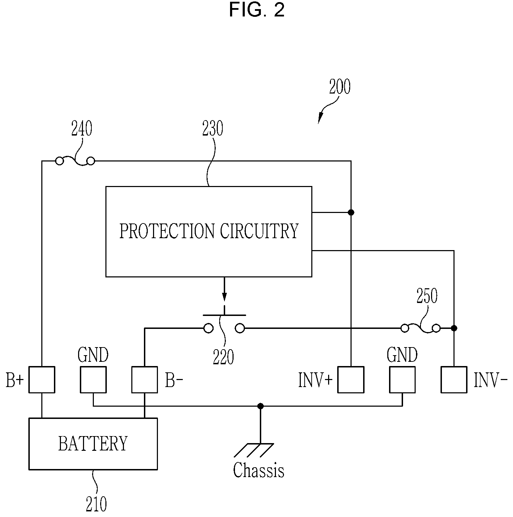

FIG. 2 is a diagram illustrating an example of an energy storage system according to some embodiments.

Referring to FIG. 2, an energy storage system 200 may include a battery 210, a switch 220, and protection circuitry 230. In some embodiments, the protection circuitry 230 may be a battery management system of the energy storage system 200 or may be included in a battery management system.

The battery 210 may be a rechargeable battery. The battery 210 may be, for example, a lithium cell such as a lithium-ion cell or a lithium-ion polymer cell, or a nickel cell such as a nickel-cadmium (NiCd) cell or a nickel-metal hydride (NiMH) cell. In some embodiments, the battery 210 may include an assembly of a plurality of battery cells, a battery module including the plurality of assemblies connected in series or parallel, a battery pack (or battery rack) including a plurality of battery modules connected in series or parallel, or a plurality of battery packs connected in series or parallel.

A positive electrode of the battery 210 may be connected to a positive battery terminal B+ of the energy storage system 200, and a negative electrode of the battery 210 may be connected to a negative battery terminal B- of the energy storage system 200. One of the positive battery terminal B+ and the negative battery terminal B- may be referred to as a first battery terminal and the other as a second battery terminal. In some embodiments, the positive battery terminal B+ and the negative battery terminal B-may be a positive battery socket B+ and a negative battery socket B-, respectively. A positive inverter terminal INV+ of the energy storage system 200 may be connected to a positive terminal of an inverter (e.g., 130 in FIG. 1), and a negative inverter terminal INV-of the energy storage system 200 may be connected to a negative terminal of the inverter 130. One of the positive inverter terminal INV+ and the negative inverter terminal INV- may be referred to as a first inverter terminal and the other as a second inverter terminal. Further, one of the positive terminal and the negative terminal of the inverter may be referred to as a first terminal and the other as a second terminal. The positive inverter terminal INV+ and the negative inverter terminal INV- may be a positive inverter socket INV+ and a negative inverter socket INV-, respectively.

In some embodiments, the positive terminal and the negative terminal of the inverter 130 may be a positive output and a negative output of the DC/DC converter 132 of the inverter 130, respectively. In some embodiments, the positive terminal and the negative terminal of the inverter 130 may be a positive input and a negative input of the inverter 131, respectively.

The switch 220 may be connected between a battery terminal of the energy storage system 200 and an inverter terminal of the energy storage system 200. In some embodiments, as shown in FIG. 2, the switch 220 may be connected between the negative battery terminal B- and the negative inverter terminal INV-. In some embodiments, the switch 220 may be connected between the positive battery terminal B+ and the positive inverter terminal INV+. In some embodiments, the switch 220 may include a switch connected between the positive battery terminal B+ and the positive inverter terminal INV+ and a switch connected between the negative battery terminal Band the negative inverter terminal INV-. In some embodiments, the switch 220 may be a conductor formed as a relay.

The ground of the energy storage system 200 may be connected to a ground terminal GND. The ground terminal GND may be referred to as a ground socket GND. In some embodiments, the ground terminal GND may be connected to a chassis ground of the energy storage system 200.

The protection circuitry 230 may receive a voltage at the positive inverter terminal INV+ and a voltage at the negative inverter terminal INV-, diagnose whether a fault occurs in the inverter 130 based on the voltage at the positive inverter terminal INV+ and the voltage at the negative inverter terminal INV-, and open the switch 220 if the inverter 130 is faulty. For example, if the inverter 130 (e.g., the DC/DC converter 132 of FIG. 1) is supplied with a voltage higher than the voltage that is actually to be provided, the protection circuitry 230 may diagnose the fault in the inverter 130 based on the voltage at the positive inverter terminal INV+ and the voltage at the negative inverter terminal INV-, and open the switch 220. Alternatively, if a short circuit occurs in a line connecting the inverter 130 to the grid 140, the protection circuitry 230 may diagnose the fault (short circuit fault) in the inverter 130 based on the voltage at the positive inverter terminal INV+ and the voltage at the negative inverter terminal INV-, and open the switch 220.

In some embodiments, a fuse 240 may be connected between the positive battery terminal B+ and the positive inverter terminal INV+. In some embodiments, a fuse 250 may be connected between the negative battery terminal B- and the negative inverter terminal INV-.

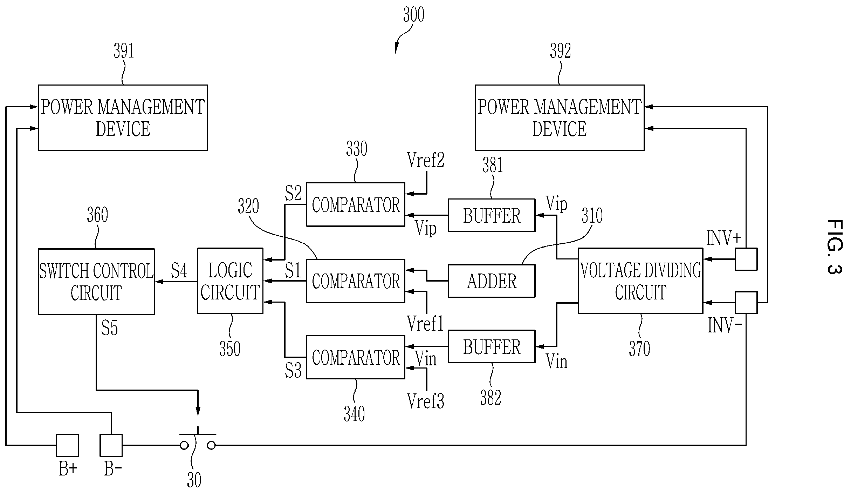

FIG. 3 is a diagram illustrating an example of protection circuitry of an energy storage system according to some embodiments.

Referring to FIG. 3, protection circuitry 300 may be connected to a positive inverter terminal INV+ and a negative inverter terminal INV- of an energy storage system, and may include an adder 310, comparators 320, 330, and 340, a logic circuit 350, and a switch control circuit 360.

The adder 310 may calculate a difference Vip-Vin between a voltage Vip detected at the positive inverter terminal INV+ (referred to as a "positive inverter voltage") and a voltage Vin detected at the negative inverter terminal INV- (referred to as a "negative inverter voltage"). The adder 310 may be referred to as a subtractor.

The comparator 320 may compare the difference Vip-Vin between the positive inverter voltage Vip and the negative inverter voltage Vin calculated by the adder 310 with a reference voltage (or first reference voltage) Vref1. The comparator 320 may output an output signal (or first output signal) S1 having a first predetermined level (or first level) if the difference Vip-Vin between the positive inverter voltage Vip and the negative inverter voltage Vin is greater than the reference voltage Vref1. The comparator 320 may output an output signal S1 having a second level different from the first predetermined level if the difference Vip-Vin between the positive inverter voltage Vip and the negative inverter voltage Vin is not greater than the reference voltage Vref1. Depending on the setting of the reference voltage Vref1, a case in which the difference Vip-Vin between the positive inverter voltage Vip and the negative inverter voltage Vin is greater than the reference voltage Vref1 may be interpreted as a case in which the difference Vip-Vin between the positive inverter voltage Vip and the negative inverter voltage Vin is greater than or equal to the reference voltage Vref1.

The comparator 330 may compare the positive inverter voltage Vip with a reference voltage (or second reference voltage) Vref2. In some embodiments, since a three-phase inverter may be used, the positive inverter voltage Vip compared by the comparator 330 may be the positive inverter voltage Vip relative to a ground terminal (e.g., GND in FIG. 2). That is, the comparator 330 may compare the positive inverter voltage Vip minus a voltage at the ground terminal GND with the reference voltage Vref2. The comparator 330 may output an output signal (or second output signal) S2 having the first predetermined level if the positive inverter voltage Vip (e.g., the positive inverter voltage Vip minus the voltage at the ground terminal GND) is greater than the reference voltage Vref2. The comparator 330 may output the output signal S2 having the second level different from the first predetermined level if the positive inverter voltage Vip is not greater than the reference voltage Vref2. Depending on the setting of the reference voltage Vref2, a case in which the positive inverter voltage Vip is greater than the reference voltage Vref2 may be interpreted as a case in which the positive inverter voltage Vip is greater than or equal to the reference voltage Vref2.

The comparator 340 may compare the negative inverter voltage Vin with a reference voltage (or third reference voltage) Vref3. In some embodiments, since a three-phase inverter may be used, the negative inverter voltage Vip compared by the comparator 340 may be the negative inverter voltage Vin relative to the ground terminal GND. That is, the comparator 340 may compare the negative inverter voltage Vin minus the voltage at the ground terminal GND to the reference voltage Vref3. The comparator 340 may output an output signal (or a third output signal) S3 having the first predetermined level if the negative inverter voltage Vip (e.g., the negative inverter voltage Vin minus the voltage at the ground terminal GND) is greater than the reference voltage Vref3. In this case, a magnitude of the negative inverter voltage Vip and a magnitude of the reference voltage Vref3 to be compared may be an absolute value of the negative inverter voltage Vip and an absolute value of the reference voltage Vref3, respectively. The comparator 340 may output an output signal S3 having the second level different from the first predetermined level if the negative inverter voltage Vin is not greater than the reference voltage Vref3. Depending on the setting of the reference voltage Vref3, a case in which the negative inverter voltage Vin is greater than the reference voltage Vref3 may be interpreted as a case in which the negative inverter voltage Vin is greater than or equal to the reference voltage Vref3.

The logic circuit 350 may output an output signal S4 based on the output signals S1, S2, and S3 output from the comparators 320, 330, and 340. The logic circuit 350 may output the output signal S4 by performing a logical operation on the output signals S1, S2, and S3 output from the comparators 320, 330, and 340. The logic circuit 350 may output the control signal having a second predetermined level (or a third level) when at least one of the output signals S1, S2, and S3 output from the comparators 320, 330, and 340 has the first predetermined level. If the output signals S1, S2, and S3 output from the comparators 320, 330, and 340 have the second level, the logic circuit 350 may output the control signal having a fourth level that is different from the second predetermined level.

In some embodiments, when the first predetermined level is a high level in a logic level, the logic circuit 350 may include an OR gate, and the second predetermined level may be the high level. In some embodiments, when the first predetermined level is the high level, the logic circuit 350 may include a negative OR (NOR) gate, and the second predetermined level may be a low level. In some embodiments, when the first predetermined level is a low level in a logic level, the logic circuit 350 may include an AND gate, and the second predetermined level may be the low level. In some embodiments, when the first predetermined level is the low level in a logic level, the logic circuitry 350 may include a negative AND (NAND) gate, and the second predetermined level may be the high-level.

The switch control circuit 360 may open a switch 30 connecting a battery terminal of the energy storage system and an inverter terminal of the energy storage system in response to the output signal S4 having the second predetermined level.

As described above, if an abnormality occurs in the voltage supplied by the inverter, the protection circuitry 300 may detect the fault in the inverter and open the switch 30 that controls the connection between the inverter and the battery of the energy storage system to prevent the fault in the inverter from affecting the energy storage system. Further, the protection circuitry may determine whether there is an abnormality in each of the difference between the positive inverter voltage and the negative inverter voltage, the positive inverter voltage, and the negative inverter voltage, so that the energy storage system may be protected even when the three-phase inverter is connected to the energy storage system.

In some embodiments, since the inverter may output a high voltage, the protection circuitry 300 may further include a voltage dividing circuit 370 so that a lower voltage may be used in the protection circuitry 300. The voltage dividing circuit 370 may include a first voltage dividing circuit that divides the voltage at the positive inverter terminal INV+ to output the positive inverter voltage Vip, and a second voltage dividing circuit that divides the voltage at the negative inverter terminal INV- to output the negative inverter voltage Vin. The voltage dividing circuit 370 may include, for example, a first voltage dividing circuit including a plurality of resistors connected in series between the positive inverter terminal INV+ and the ground terminal GND and a second voltage dividing circuit including a plurality of resistors connected in series between the negative inverter terminal INV- and the ground terminal GND.

In some embodiments, the protection circuitry 300 may further include a high-voltage buffer (or first buffer) 381 and a low-voltage buffer (or second buffer) 382. The high-voltage buffer 381 may store the positive inverter voltage Vip detected by the voltage dividing circuit 370, and the low-voltage buffer 382 may store the negative inverter voltage Vin detected by the voltage dividing circuit 370.

In some embodiments, the protection circuitry 300 may further include a power management device 391 and/or a power management device 392. The power management device 391 may be connected to the positive battery terminal B+ and the negative battery terminal B- to generate voltages used by components of the protection circuitry 300 based on the voltage of the battery. The power management device 392 may be connected to the positive inverter terminal INV+ and the negative inverter terminal INV- to generate voltages used by the components of the protection circuitry 300 based on the voltage supplied by the inverter. In some embodiments, the power management devices 391 and/or 392 may include a DC/DC converter.

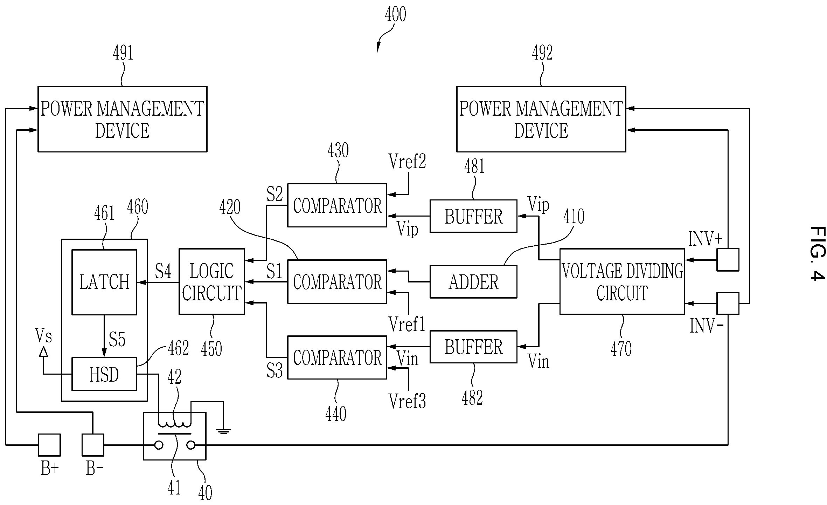

FIG. 4 is a diagram illustrating an example of protection circuitry of an energy storage system according to some embodiments.

Referring to FIG. 4, protection circuitry 400 may include an adder 410, comparators 420, 430, and 440, a logic circuit 450, and a switch control circuit 460. In some embodiments, the protection circuitry 400 may further include a voltage dividing circuit 470, a high-voltage buffer 481, and a low-voltage buffer 482. In some embodiments, the protection circuitry 400 may further include a power management device 491 and/or 492. The adder 410, the comparators 420, 430, and 440, the logic circuit 450, the voltage dividing circuit 470, the high-voltage buffer 481, the low-voltage buffer 482, and the power management devices 491 and 492 operate identically or similarly to the adder 310, the comparators 320, 330, and 330, the logic circuit 350, the voltage dividing circuit 370, the high-voltage buffer 381, the low-voltage buffer 382, and the power management devices 391 and 392 described with reference to FIG. 3, and therefore their descriptions are omitted.

The switch control circuit 460 may include a latch 461 and a driver 462. The latch 461 may output a control signal S5 having a second predetermined level in response to an output signal S4 having a second predetermined level from the logic circuit 450.

A switch 40 connecting a battery terminal of an energy storage system and an inverter terminal of the energy storage system may include a relay switch 41 and a relay coil 42.

The relay switch 41 may be connected between the battery terminal and the inverter terminal. The relay coil 42 may be provided for driving the relay switch 41. The driver 462 may be connected between a power source supplying a supply voltage Vs and a first terminal of the relay coil 42, and a second terminal of the relay coil 42 may be connected to a terminal having a potential lower than the supply voltage Vs, for example, a ground terminal GND. For convenience, the terminal having the potential lower than the supply voltage Vs is described as the ground terminal GND. The power source supplying the supply voltage Vs may be, for example, the power management device 491 and/or 492.

The driver 462 may control an electrical connection between the power source supplying the supply voltage Vs and the first terminal of the relay coil 42, and may include, for example, a switch such as a transistor. Such the driver 462 may be referred to as a high-side driver (HSD). When the power source supplying the supply voltage Vs is connected to the first terminal of the relay coil 42 by the driver 462, current may flow through the relay coil 42, a magnetic field may be generated by the current, and the magnetic field may cause contacts of the relay switch 41 to be connected, thereby closing the switch 40. The driver 462 may disconnect the power source supplying the supply voltage Vs and the first terminal of the relay coil 42 in response to the control signal S5 having the second predetermined level from the latch 461. Accordingly, the current flowing through the relay coil 42 may be cut off, thereby breaking the contacts of the relay switch 41 and causing the switch 40 to open.

In some embodiments, the first terminal of the relay coil 42 may be connected to the power source supplying the supply voltage Vs, and the driver 462 may be connected between the second terminal of the relay coil 42 and the ground terminal. Such the driver 462 may be referred to as a low-side driver (LSD). In some embodiments, the driver 462 may include a driver connected between the first terminal of the relay coil 42 and the power source supplying the supply voltage Vs, and a driver connected between the second terminal of the relay coil 42 and the ground terminal.

As described above, if an abnormality occurs in the voltage supplied by the inverter, the protection circuitry 400 may detect the fault in the inverter and open the switch 40 that controls the connection between the inverter and the battery of the energy storage system to prevent the fault in the inverter from affecting the energy storage system. Further, the protection circuitry may determine whether there is an abnormality in each of the difference between the positive inverter voltage and the negative inverter voltage, the positive inverter voltage, and the negative inverter voltage, so that the energy storage system may be protected even when the three-phase inverter is connected to the energy storage system.

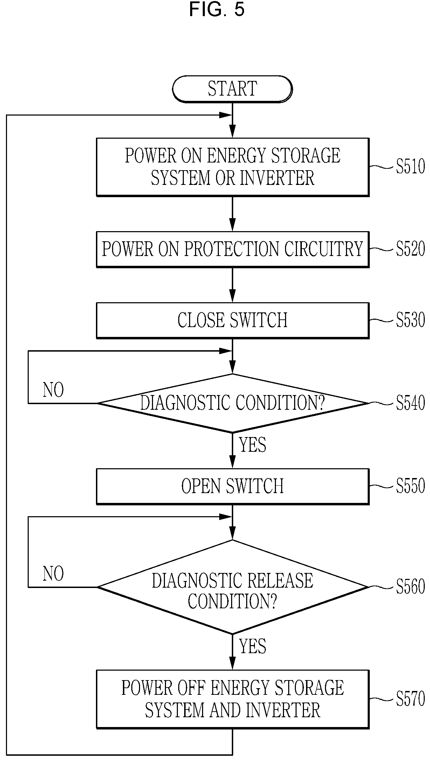

FIG. 5 is a flowchart illustrating an example of a protection method of an energy storage system according to some embodiments.

Referring to FIG. 5, when an energy storage system or an inverter is powered on (S510), protection circuitry may be powered on (S520) and a switch that controls a connection between a battery of the energy storage system and the inverter may be closed (S530). In some embodiments, when the energy storage system is powered on, a power management device may use a voltage from the battery of the energy storage system to provide power to the protection circuitry. In some embodiments, when the inverter is powered on, the power management device may use a voltage from the inverter to provide power to the protection circuitry.

The protection circuitry may determine whether voltages of the inverter (i.e., a positive inverter voltage and a negative inverter voltage) satisfy a diagnostic condition (S540). In some embodiments, the diagnostic condition may include a first diagnostic condition in which a difference between the positive inverter voltage and the negative inverter voltage is greater than a first reference voltage, a second diagnostic condition in which the positive inverter voltage is greater than a second reference voltage, and/or a third diagnostic condition in which the negative inverter voltage is greater than a third reference voltage. In some embodiments, the positive inverter voltage compared to the second reference voltage may be a positive inverter voltage relative to a ground (e.g., chassis ground) of the energy storage system. In some embodiments, the negative inverter voltage compared to the third reference voltage may be a negative inverter voltage relative to the ground (e.g., chassis ground) of the energy storage system.

If at least one of the first diagnostic condition, the second diagnostic condition, and the third diagnostic condition is satisfied (S540: yes), the protection circuitry may open the switch (S550). In some embodiments, if the difference between the positive inverter voltage and the negative inverter voltage is greater than the first reference voltage, the positive inverter voltage is greater than the second reference voltage, or the negative inverter voltage is greater than the third reference voltage, the protection circuitry may open the switch (S550). If the diagnostic condition is not satisfied (S540: no), the protection circuitry may monitor the voltages of the inverter to determine whether the diagnostic conditions is satisfied.

In some embodiments, the protection circuitry may determine whether the voltages of the inverter satisfy a diagnostic release condition after opening the switch (S560). In some embodiments, the diagnostic release condition may include a condition in which the difference between the positive inverter voltage and the negative inverter voltage is not greater than the first reference voltage, a condition in which the positive inverter voltage is not greater than the second reference voltage, and a condition in which the negative inverter voltage is not greater than the third reference voltage. That is, if the difference between the positive inverter voltage and the negative inverter voltage is not greater than the first reference voltage, the positive inverter voltage is not greater than the second reference voltage, and the negative inverter voltage is not greater than the third reference voltage, the protection circuitry may determine that the diagnostic release condition is satisfied (S560: yes).

If the diagnostic release condition is satisfied (S560: yes), the protection circuitry may power off the energy storage system (S570) and then power on the energy storage system again (S510), in order to close the switch. In some embodiments, if the diagnostic release condition is satisfied (S560: yes), the protection circuitry may power off the inverter (S570) and then power on the inverter again (S510).

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. An energy storage system comprising:
a battery;
a first battery terminal and a second battery terminal to which the battery is connected;
a first inverter terminal and a second inverter terminal to which an inverter is connected;
a switch connected between the second battery terminal and the second inverter terminal; and
protection circuitry configured to determine whether to open the switch based on a difference between a first voltage detected at the first inverter terminal and a second voltage detected at the second inverter terminal, the first voltage, and the second voltage.

2. The energy storage system of claim 1, wherein the protection circuitry is further configured to:
determine a first diagnostic condition in which the difference between the first voltage and the second voltage is greater than a first reference voltage, a second diagnostic condition in which the first voltage is greater than a second reference voltage, and a third diagnostic condition in which the second voltage is greater than a third reference voltage; and
open the switch in response to at least one of the first diagnostic condition, the second diagnostic condition, and the third diagnostic condition being satisfied.

3. The energy storage system of claim 2, wherein the protection circuitry is further configured to power off the energy storage system and then power on the energy storage system again, in response to the difference between the first voltage and the second voltage being not greater than the first reference voltage, the first voltage being not greater than the second reference voltage, and the second voltage being not greater than the third reference voltage, after opening the switch.

4. The energy storage system of claim 1, wherein the inverter is a three-phase inverter, and
wherein the first voltage is a voltage relative to a ground of the energy storage system, and the second voltage is a voltage relative to the ground of the energy storage system.

5. The energy storage system of claim 1, wherein the protection circuitry comprises:
an adder configured to calculate the difference between the first voltage and the second voltage;
a first comparator configured to compare the difference between the first voltage and the second voltage with a first reference voltage;
a second comparator configured to compare the first voltage with a second reference voltage;
a third comparator configured to compare the second voltage with a third reference voltage;
a logic circuit configured to perform a logical operation on a first output signal of the first comparator, a second output signal of the second comparator, and a third output signal of the third comparison circuit; and
a switch control circuit configured to control the switch based on a fourth output signal of the logic circuit.

6. The energy storage system of claim 5, wherein the switch comprises:
a relay switch connected between the second battery terminal and the second inverter terminal; and
a relay coil configured to drive the relay switch, and
wherein the switch control circuit comprises:
a latch configured to output a control signal in response to the fourth output signal; and
a driver connected to a terminal of the relay coil and configured to disconnect a connection between the relay coil and a power source in response to a predetermined level of the control signal.

7. The energy storage system of claim 5, wherein the first comparator is further configured to output the first output signal having a first predetermined level in response to the difference between the first voltage and the second voltage being greater than the first reference voltage,
wherein the second comparator is further configured to output the second output signal having the first predetermined level in response to the first voltage being greater than the second reference voltage,
wherein the third comparator is further configured to output the third output signal having the first predetermined level in response to the second voltage being greater than the third reference voltage,
wherein the logic circuit is further configured to output the fourth output signal having a second predetermined level in response to at least one of the first output signal, the second output signal, and the third output signal having the first predetermined level, and
wherein the switch control circuit is further configured to open the switch in response to the second predetermined level of the fourth output signal.

8. The energy storage system of claim 5, wherein the protection circuitry further comprises a voltage dividing circuit configured to divide a voltage at the first inverter terminal to output the first voltage and divide a voltage at the second inverter terminal to output the second voltage.

9. A protection apparatus of an energy storage system comprising a battery and a switch configured to a connection between the battery and an inverter, the protection apparatus comprising:
a voltage dividing circuit configured to divide a voltage at a first inverter terminal connected to a first terminal of the inverter to output a first voltage, and divide a voltage at a second inverter terminal connected to a second terminal of the inverter to output a second voltage;
an adder configured to calculate a difference between the first voltage and the second voltage;
a first comparator configured to compare the difference between the first voltage and the second voltage with a first reference voltage;
a second comparator configured to compare the first voltage with a second reference voltage;
a third comparator configured to compare the second voltage with a third reference voltage;
a logic circuit configured to perform a logical operation on a first output signal of the first comparator, a second output signal of the second comparator, and a third output signal of the third comparator; and
a switch control circuit configured to control the switch based on a fourth output signal of the logic circuit.

10. The protection apparatus of claim 9, wherein the first comparator is further configured to output the first output signal having a first predetermined level in response to the difference between the first voltage and the second voltage being greater than the first reference voltage;
wherein the second comparator is further configured to output the second output signal having the first predetermined level in response to the first voltage being greater than the second reference voltage;
wherein the third comparator is further configured to output the third output signal having the first predetermined level in response to the second voltage being greater than the third reference voltage;
wherein the logic circuit is further configured to output the fourth output signal having a second predetermined level in response to at least one of the first output signal, the second output signal, and the third output signal having the first predetermined level; and
wherein the switch control circuit is further configured to open the switch in response to the second predetermined level of the fourth output signal.

11. The protection apparatus of claim 9, wherein the logic circuit is further configured to output the fourth output signal having a predetermined level in response to the first output signal indicating the difference between the first voltage and the second voltage is greater than the first reference voltage, the second output signal indicating the first voltage is greater than the second reference voltage, or the third output signal indicating the second voltage is greater than the third reference voltage, and
wherein the switch control circuit is further configured to output the switch in response to the predetermined level of the fourth output signal.

12. The protection apparatus of claim 9, further comprising:
a first buffer configured to store the first voltage; and
a second buffer configured to store the second voltage.

13. The protection apparatus of claim 9, wherein the inverter is a three-phase inverter, and
wherein the first voltage is a voltage relative to a ground of the energy storage system, and the second voltage is a voltage relative to the ground of the energy storage system.

14. A method of protecting an energy storage system comprising a battery and a switch configured to control a connection between the battery and an inverter, the method comprising:
detecting a voltage at a first inverter terminal connected to a first terminal of the inverter to output a first voltage;
detect a voltage at a second inverter terminal connected to a second terminal of the inverter to output a second voltage;
comparing a difference between the first voltage and the second voltage with a first reference voltage;
comparing the first voltage with the second reference voltage;
comparing the second voltage with a third reference voltage; and
opening the switch in response to the difference between the first voltage and the second voltage being greater than the first reference voltage, the first voltage being greater than the second reference voltage, or the second voltage being greater than the third reference voltage.

15. The method of claim 14, further comprising powering off the energy storage system and then powering on the energy storage system again, in response to the difference between the first voltage and the second voltage being not greater than the first reference voltage, the first voltage being not greater than the second reference voltage, and the second voltage being not greater than the third reference voltage, after opening the switch
